**Europäisches Patentamt**

**European Patent Office**

**Office européen des brevets**

(19)

(11) Veröffentlichungsnummer: **0 176 908**
**B1**

# EUROPÄISCHE PATENTSCHRIFT

(12)

(45) Veröffentlichungstag der Patentschrift:
24.01.90

(21) Anmeldenummer: 85112020.4

(22) Anmeldetag: 23.09.85

(51) Int. Cl.⁴: **H03K 19/086**

(54) **UND-Gatter für ECL-Schaltungen.**

(30) Priorität: 24.09.84 DE 3435004

(43) Veröffentlichungstag der Anmeldung:
09.04.86 Patentblatt 86/15

(45) Bekanntmachung des Hinweises auf die Patenterteilung:
24.01.90 Patentblatt 90/4

(84) Benannte Vertragsstaaten:
AT DE FR GB IT NL

(56) Entgegenhaltungen:
EP-A- 0 035 326
US-A- 3 649 844
US-A- 4 394 657

PATENTS ABSTRACTS OF JAPAN, Band 6, Nr. 171, 4.
September 1982, Seite P140 1049, & JP - A - 57 88 593

(73) Patentinhaber: Siemens Aktiengesellschaft,
Wittelsbacherplatz 2, D-8000 München 2(DE)

(72) Erfinder: Wilhelm, Wilhelm, Dr., Geigenbergerstrasse 23,
D-8000 München 71(DE)
Erfinder: Schön, Karl-Reinhard, Dipl.-Ing.,
Stephansplatz 1, D-8000 München 2(DE)

## Beschreibung

Die vorliegende Erfindung betrifft die Realisierung von UND-Verknüpfungen in Emitter-coupledlogic (ECL)-Schaltkreisen nach dem Oberbegriff des Patentanspruches 1.

ECL-Logikbausteine zeichnen sich durch besondere Schnelligkeit aus, weil keine Sättigung der Transistoren auftritt. Das Schaltungsprinzip beruht darauf, daß in einen Differenzverstärker ein konstanter Emitterstrom eingespeist wird und die Basis des ersten der Transistoren eine Vorspannung zwischen dem L- und H-Pegel besitzt. Je nach dem Potential der Basis des zweiten Transistors übernimmt dieser oder der erste Transistor den Strom, der am jeweils zugehörigen Kollektorwiderstand einen den Ausgangszustand bestimmenden Spannungsabfall hervorruft. UND-Verknüpfungen sind sehr einfach durch Seriesgating realisierbar, bei dem mehrere derartige Stufen übereinander liegen, d.h. die Kollektoren der untersten Pegelebene jeweils mit den Emittern der zur nächsthöheren Potentialebene gehörenden Differenzstufe verbunden sind und nur die oberste Ebene Kollektorwiderstände besitzt (vgl. US-A 3 649 844, Spalte 4, Zeile 54 ff). Bei ODER-Gattern führen die Kollektoren der obersten Potentialebene zu einem Knotenpunkt und von dort zum Kollektorwiderstand.

Die Zahl der Eingangsvariablen bei UND-Verknüpfungen ist begrenzt durch die Anzahl der möglichen Seriesgating-Stufen, deren Pegel sich um je eine Diodenspannung unterscheiden. Um einen ausreichenden Signalhub zu gewährleisten, können unter Berücksichtigung der erforderlichen Stromquellen bei 4,5 bis 5,2 V-Versorgungsspannungen maximal drei Stufen übereinander liegen.

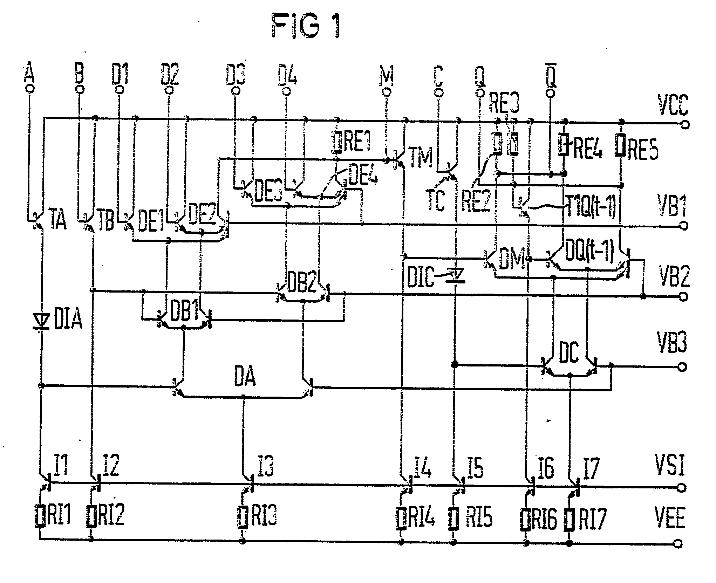

Die Realisierung von mehr als drei Eingangsvariablen in einem UND-Gatter erfolgt nach dem Stand der Technik durch Hintereinanderschalten mehrerer Seriesgating-Gatter, in denen jeweils Teilverknüpfungen durchgeführt werden. Dabei entsteht aus drei Eingangsvariablen ein (Hilfs-)Ausgangssignal, das einen Eingang des nächstfolgenden Gatters ansteuert. Beispielsweise erfordern vier Eingangsvariable drei Seriesgating-Stufen des ersten und zwei Stufen des zweiten Gatters, wie in Fig. 1 am Beispiel einer Schaltung eines 4-Bit-Multiplexers mit Latch dargestellt wird.

Die zum Schaltungsbeispiel der Fig. 1 gehörende logische Funktion lautet: $Q(t) = A \cdot B \cdot C \cdot D1 + A \cdot \overline{B} \cdot C \cdot D2 + \overline{A} \cdot B \cdot C \cdot D3 + \overline{A} \cdot \overline{B} \cdot C \cdot D4 + Q(t-1) \cdot \overline{C}$. Die maximal vier Eingangsvariablen der UND-Gatter erfordern zwei hintereinandergeschaltete Seriesgating-Gatter. Das erste Gatter realisiert die logische Funktion $M = A \cdot B \cdot D1 + A \cdot \overline{B} \cdot D2 + \overline{A} \cdot B \cdot D3 + \overline{A} \cdot \overline{B} \cdot D4$ und das zweite Gatter die logische Funktion $Q(t) = M \cdot C + Q(t-1) \cdot \overline{C}$. Auf der untersten Pegelebene VSI befinden sich die die Schaltung versorgenden Konstantstromquellen I1 bis I7 mit ihren Emitterwiderständen RI1 bis RI7. Die beiden Differenzverstärker DA und DC der untersten Seriesgating-Stufe mit der Basisvorspannung VB3 werden von den Emitterfolgern TA und TC und deren Eingängen A und C gesteuert. Die Dioden DIA und DIC dienen zur Pegelanpassung an die nächsthöhere Stufe mit der Basisvorspannung VB2 für die Differenzstufen DB1, DB2, DM und DQ(t-1), die von den Emitterfolgern TB, TM und T1Q(t-1) mit den Eingängen B und M und, in Verbindung mit dem Basisvorwiderstand RE 3, von Q gesteuert werden. Dieser Ebene übergeordnet ist die dritte Seriesgating-Stufe mit den Differenzverstärkern DE1 bis DE4 und den Eingängen D1 bis D4. Die zugehörige Vorspannung VB1 liegt an den Basen zweier Zwei-Emitter-Transistoren, deren Kollektoren zusammengeführt sind und eine ODER-Verknüpfung in Verbindung mit dem gemeinsamen Kollektorwiderstand RE1 bilden. Ihr Kollektorpotential steuert über den Transistor TM den Eingang M des in Serie liegenden zweiten Seriesgating-Gatters, dessen Ausgangszustände Q und $\overline{Q}$ an den Kollektoren der Differenzstufen DM und DQ(t-1) und ihren Lastwiderständen RE2, RE4 und RE5 anstehen und den Ausgang der Schaltung bilden.

Nachteile dieser Methode sind die relativ langen Gatterlaufzeiten, die abhängig von der Zahl der zu durchlaufenden Seriesgating-Stufen sind und beispielsweise für die Schaltung nach Fig. 1 für das Signal Di nach Q 1,07 ns, für A nach Q 1,33 ns und für B nach Q 1,20 ns typisch betragen, der durch den hohen Schaltungsaufwand bedingte vergleichsweise hohe Leistungsbedarf und die vielfach nicht optimale Nutzung der Seriesgating-Stufen.

Der Erfindung liegt die Aufgabe zugrunde, durch schaltungstechnische Maßnahmen die Zahl der Eingangsvariablen zu erhöhen und die Signallaufzeit zu verkürzen.

Diese Aufgabe wird bei einer Anordnung der eingangs erwähnten Art erfindungsgemäß durch die Merkmale des Kennzeichens des Patentanspruchs 1 gelöst.

Ausgestaltungen des vorstehend definierten Erfindungsgedankens sind in den Unteransprüchen gekennzeichnet.

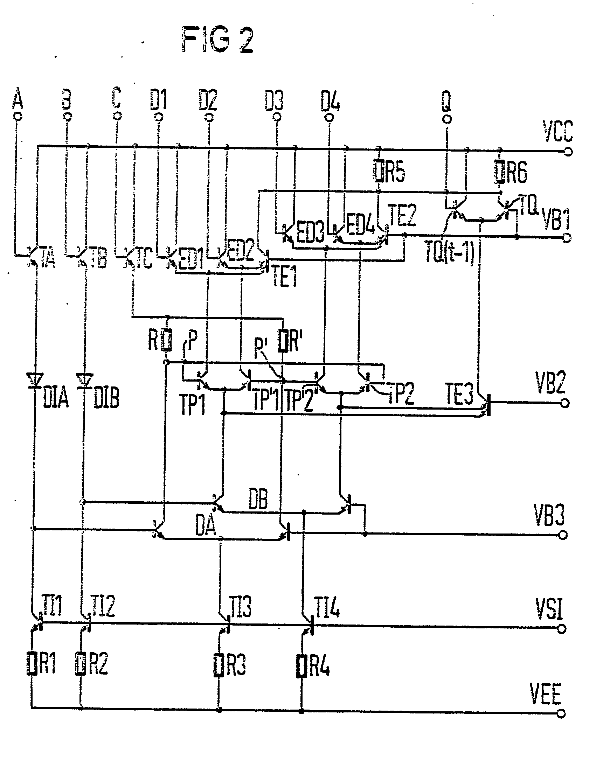

Die Erfindung wird im folgenden anhand eines in Fig. 2 der Zeichnung dargestellten Ausführungsbeispiels näher erläutert. Gleiche Elemente wie in Fig. 1 sind dabei mit gleichen Bezugszeichen versehen.

Fig. 2 zeigt, entsprechend zu Fig. 1, eine Schaltung eines 4-Bit-Multiplexers mit Latch, wenn drei Seriesgating-Stufen zur Verfügung stehen.

Das in Fig. 2 dargestellte Beispiel einer erfindungsgemäßen Schaltung realisiert dieselbe logische Funktion wie Fig. 1. Das Prinzip der Erfindung besteht darin, eine zusätzliche UND-Verknüpfung zwischen zwei Eingangssignalen derart einzuführen, daß der ausgewählte Zweig stets auf dem von einem der Signale allein bestimmten Spannungspegel liegt und die zusätzlichen Hilfssignale so klein, daß der vom anderen Signal gesteuerte ECL-Stromschalter eine Pegelebene tiefer liegen kann, ohne daß Sättigungsgefahr besteht. Diese Forderungen erfüllt z.B. eine in der mittleren Pegelebene liegende Gegentaktschaltung.

Die Schaltung nach Fig. 2 wird von vier Stromquellen gespeist, die jeweils einen von der gemeinsamen Basisspannung VSI angesteuerten Transistor, TI1 bis TI4, nebst zugehörigem Emitterwiderstand, R1 bis R4, enthalten. Diese wiederum liegen mit ihrem anderen Anschluß am Pol VEE der Versorgungsspannungsquelle.

Eine Pegelebene höher, auf der unteren Series-gating-Stufe, befinden sich die beiden Differenzverstärker DA und DB mit der Basisvorspannung VB3 für jeden Referenzkreis, die von den Strom-quellentransistoren TI3 und TI4 gespeist und von den auf der obersten Seriesgating-Stufe angeordneten Eingangs-Emitterfolgern TA und TB und deren Eingangssignalen A und B gesteuert werden. Zur Pegelanpassung der beiden Seriesgating-Stufen dienen die den Emittern von TA und TB nachgeschalteten Dioden DIA und DIB, denen über die Kollektoren von TI1 und TI2 der Durchlaßstrom eingeprägt wird. Die Kathoden von DIA und DIB sind zusätzlich mit den Basisanschlüssen der nicht von VB3 vorgespannten Steuertransistoren der Differenzstufen DA und DB verbunden. Auf der nächsthöheren Pegelebene, der mittleren Seriesgating-Stufe, liegt die Vorspannung VB2 an der Basis des Zweiemittertransistors TE3. Die beiden Emitter sind je mit den Emittern zweier zur gleichen Pegelebene gehörender Differenzverstärker und mit den Kollektoren der Differenzstufe DB verbunden. Der Kollektor des nicht von VB3 vorgespannten Steuertransistors der DB-Stufe ist den Emittern von TP1 und TP'1, der andere Kollektor den Emittern von TP2 und TP'2 zugeordnet. Den gemeinsamen Basisanschluß P der Transistoren TP1 und TP2 steuert über den Widerstand R der Ausgang des Emitterfolgers TC mit dem Eingangssignal C und der Kollektor des nicht von VB3 vorgespannten Steuertransistors der Differenzstufe DA. In gleicher Weise ist der Basisanschluß P' der Transistoren TP'1 und TP'2 über R' ebenfalls mit dem Emitterfolger TC und mit dem Kollektor des von VB3 vorgespannten Transistors der Differenzstufe DA verbunden. Der Punkt P realisiert die Verknüpfung P = $\overline{A}$ C, für den Punkt P' gilt P'= A $\overline{C}$. Das an den Widerständen R bzw. R' erzeugte zusätzliche Signal kann wegen des Gegentaktprinzips sehr klein bemessen werden, so daß der vom Signal A gesteuerte ECL-Stromschalter DA nicht in die Sättigung gelangen kann.

Die obere Seriesgating-Stufe enthält die von den Datensignalen D1 bis D4 gesteuerten ECL-Stromschalter, die in zwei Zweiergruppen mit je einem Zweiemittertransistor zusammengefaßt sind, und den Latch. An den Basen der Zweiemittertransistoren TE1 und TE2 sowie des Latchtransistors TQ liegt die Vorspannung VB1. Ein Emitter von TE1 ist mit dem Emitter des von D1 gesteuerten Transistors ED1 und dem Kollektor von TP1, der andere Emitter von TE1 ist mit dem Emitter des von D2 gesteuerten Transistors ED2 und dem Kollektor von TP'1 verbunden. In ähnlicher Weise ist ein Emitter von TE2 am Emitter des von D3 gesteuerten Transistors ED3 und dem Kollektor von TP'2 angeschlossen und der andere Emitter von TE2 am Emitter des von D4 gesteuerten Transistors ED4 und dem Kollektor von TP2. Die Emitter der den Latch realisierenden Differenzverstärkerstufe aus TQ und TQ(t-1) liegen in Serie zum Kollektor des Zweiemittertransistors TE3, der das Signal $\overline{C}$ hervorbringt. Der Kol-lektor von TQ ist auf die Basis von TQ(t-1) rückgekoppelt. Während die Kollektoren der in dieser Ebene nicht von VB1 vorgespannten (Eingangs-)-Transistoren direkt am Pol VCC der Versorgungsspannungsquelle liegen, bilden die über die Parallelschaltung der Widerstände R5 und R6 nach VCC geschalteten zusammengelegten Kollektoren der Transistoren TE1, TE2 und TQ den gemeinsamen Ausgang Q. Die Schaltung nach Fig. 2 ermöglicht gegenüber einer die gleiche logische Funktion realisierenden Schaltung nach Fig. 1 mit zwei hinterein-andergeschalteten Seriesgating- Gattern die Re-duktion der Laufzeiten von Di nach Q um ca. ca. 35%, von A nach Q um ca. 10% und von B nach Q um ca. 25%. Gleichzeitig verringert sich die benötigte Verlustleistung bei der erfindungsgemäßen Schaltung nach Fig. 2 um mehr als 35%.

## Patentansprüche

1. Halbleiterschaltungsanordnung in ECL-Technik zur Realisation logischer Konjunktionen zwischen mehr als drei Eingangsvariablen mit mindestens zwei Seriesgating-Stufen, bei denen von je einer Eingangsvariablen gesteuerte je einen Referenz- und mindestens einen Steuerkreis enthaltende ECL-Stromschalter in durch mindestens eine Diodenschwellspannung voneinander getrennten Spannungspegelstufen hintereinandergeschaltete logische Konjunktionen ergeben, dadurch gekennzeichnet, daß zwei den Steuerkreis eines ECL-Stromschalters bildende, jeweils aus einem emitter-gekoppelten Transistorpaar bestehende Differenz-verstärker (TP1, TP'1; TP2, TP'2) eingangsseitig komplementär miteinander verschaltet und über jeweils einen Widerstand (R, R') mit dem Ausgang eines gemeinsamen Emitterfolgers (TC) verbunden sind und daß der Steuerkreis (ED1 bis ED4, TP1, TP'1, TP2, TP'2) eine logische Konjunktion zwischen Eingangssignalen der beiden Differenzverstärker (TP1, TP'1; TP2, TP'2) und mindestens einem von einer Eingangsvariablen (A, B, C; D1 bis D4) abhängigen Signal einer anderen Spannungspegelstufe (VB1, VB3) realisiert.

2. Halbleiterschaltungsanordnung nach Anspruch 1, dadurch gekennzeichnet, daß die Eingangsvariablen (A, B, C, D1 bis D4) Adressiersignale (A, B, C) und/oder Datensignale (D1 bis D4) und ihre Komplementärsignale sind.

3. Halbleiterschaltungsanordnung nach Anspruch 1 oder 2, dadurch gekennzeichnet, daß ein Teil der Eingangsvariablen (D1 bis D4) die oberste Spannungspegelstufe (VB1) ansteuern.

4. Halbleiterschaltungsanordnung nach einem der Ansprüche 1 bis 3, dadurch gekennzeichnet, daß Eingangsvariable (A, B, C) Steuerkreise von Seriesgating-Stufen über Emitterfolger (TA, TB, TC) ansteuern.

5. Halbleiterschaltungsanordnung nach einem der Ansprüche 1 bis 4, dadurch gekennzeichnet, daß eine Seriesgating-Stufe mindestens zwei von je einer Eingangsvariablen (A, B, C, D1 bis D4) gesteuerte ECL-Stromschalter (DA, DB; ED1 bis ED4) enthält.

6. Halbleiterschaltungsanordnung nach einem der Ansprüche 1 bis 5, dadurch gekennzeichnet, daß mindestens ein Steuerkreis (ED1 bis ED4, TP1, TP'1, TP2, TP'2) von ECL-Stromschaltern einen Transistor (ED1 bis ED4) und/oder die beiden Differenzverstärker (TP1, TP'1, TP2, TP'2) enthält.

7. Halbleiterschaltung nach einem der Ansprüche 1 bis 6, dadurch gekennzeichnet, daß mindestens ein Steuerkreis und/oder ein Referenzkreis (TE1 bis TE2) mindestens zweier ECL-Stromschalter einer Seriesgating-Stufe mindestens einen Mehremittertransistor enthält.

8. Halbleiterschaltungsanordnung nach einem der Ansprüche 1 bis 7, dadurch gekennzeichnet, daß die Widerstände (R, R') eine logische Konjunktion zwischen Adressiersignalen (A, B, C) und/oder Datensignalen (D1 bis D4) und/oder von diesen abhängigen Signalen und/oder Ausgangssignalen einer Spannungspegelstufe (VB2, VB3) realisieren.

9. Halbleiterschaltungsanordnung nach einem der Ansprüche 1 bis 8, dadurch gekennzeichnet, daß die Eingangssignale der beiden Differenzverstärker (TP1, TP'1, TP2, TP'2) komplementäre Ausgangssignale einer Seriesgating-Stufe sind.

10. Halbleiterschaltungsanordnung nach einem der Ansprüche 1 bis 8, dadurch gekennzeichnet, daß die Eingangssignale der beiden Differenzverstärker (TP1, TP'1, TP2, TP'2) aus der logischen Konjunktion komplementärer Ausgangssignale einer Seriesgating-Stufe und einem von einer Eingangsvariablen (C) abhängigen Signal durch Spannungsaddition an den Widerständen (R, R') gebildet sind.

11. Halbleiterschaltungsanordnung nach einem der Ansprüche 1 bis 10, dadurch gekennzeichnet, daß die Widerstände (R, R') zur schaltungsinternen Spannungspegelanpassung dienen.

**Claims**

1. Semiconductor circuit arrangement in ECL technology for the realization of logical conjunctions between more than three input variables with at least two series-gating stages, in which ECL current switches that are controlled in each case by one input variable, and that contain in each case one reference circuit and at least one control circuit produce, in voltage level stages separated from one another by at least one diode threshold voltage, series-connected logical conjunctions, characterized in that two differential amplifiers (TP1, TP'1; TP2, TP'2), which form the control circuit of an ECL current switch and consist in each case of an emitter-coupled transistor pair, are connected to one another in a complementary manner on the input side, and are connected via in each case one resistor (R, R') to the output of a common emitter follower (TC), and in that the control circuit (ED1 to ED4, TP1, TP'1, TP2, TP'2) realizes a logical conjunction between input signals of the two differential amplifiers (TP1, TP'1; TP2, TP'2) and at least one signal of another voltage level stage (VB1, VB3) dependent on an input variable (A, B, C; D1 to D4).

2. Semiconductor circuit arrangement according to Claim 1, characterized in that the input variables (A, B, C, D1 to D4) are addressing signals (A, B, C) and/or data signals (D1 to D4) and their complementary signals.

3. Semiconductor circuit arrangement according to Claim 1 or 2, characterized in that a portion of the input variables (D1 to D4) control the top voltage level stage (VB1).

4. Semiconductor circuit arrangement according to one of Claims 1 to 3, characterized in that input variables (A, B, C) control control circuits of series-gating stages via emitter followers (TA, TB, TC).

5. Semiconductor circuit arrangement according to one of Claims 1 to 4, characterized in that a series-gating stage contains at least two ECL current switches (DA, DB; ED1 to ED4) controlled in each case by one input variable (A, B, C, D1 to D4).

6. Semiconductor circuit arrangement according to one of Claims 1 to 5, characterized in that at least one control circuit (ED1 to ED4, TP1, TP'1, TP2, TP'2) of ECL current switches contains a transistor (ED1 to ED4) and/or the two differential amplifiers (TP1, TP'1, TP2, TP'2).

7. Semiconductor circuit arrangement according to one of Claims 1 to 6, characterized in that at least one control circuit and/or one reference circuit (TE1 to TE2) of at least two ECL current switches of a series-gating stage contains at least one multi-emitter transistor.

8. Semiconductor circuit arrangement according to one of Claims 1 to 7, characterized in that the resistors (R, R') realize a logical conjunction between addressing signals (A, B, C) and/or data signals (D1 to D4) and/or signals dependent on the latter and/or output signals of a voltage level stage (VB2, VB3).

9. Semiconductor circuit arrangement according to one of Claims 1 to 8, characterized in that the input signals of the two differential amplifiers (TP1, TP'1, TP2, TP'2) are complementary output signals of a series-gating stage.

10. Semiconductor circuit arrangement according to one of Claims 1 to 8, characterized in that the input signals of the two differential amplifiers (TP1, TP'1, TP2, TP'2) are formed from the logical conjunction of complementary output signals of a series-gating stage and a signal dependent on an input variable (C) by means of voltage addition at the resistors (R, R').

11. Semiconductor circuit arrangement according to one of Claims 1 to 10, characterized in that the resistors (R, R') serve for circuit-internal voltage level adjustment.

**Revendications**

1. Circuit à semi-conducteurs en technique ECL pour réaliser des conjonctions logiques entre plus de trois variables d'entrée, comprenant au moins deux étages à couplage combinatoire sériel, dans lesquels des interrupteurs de courant ECL, commandés chacun par une variable d'entrée et contenant chacun un circuit de référence et au moins un circuit de commande, réalisent des conjonctions logiques prévues l'une derrière l'autre dans des étages de niveau de tension séparés l'un de l'autre par au moins une tension de seuil de diode, caractérisé en ce que deux amplificateurs différentiels (TP1, TP'1; TP2, TP'2), formant le circuit de commande d'un interrupteur de courant ECL et constitués chacun d'une paire de transistors couplés par les émet-

teurs, sont connectés ensemble, côté entrée, de façon complémentaire et sont reliés chacun à travers une résistance (R, R') à la sortie d'un émetteur-suiveur (TC) commun et que le circuit de commande (ED1 à ED4, TP1, TP'1, TP2, TP'2) réalise une conjonction logique entre des signaux d'entrée des deux amplificateurs différentiels (TP1, TP'1; TP2, TP'2) et au moins un signal, dépendant d'une variable d'entrée (A, B, C; D1 à D4), d'un autre étage de niveau de tension (VB1, VB3).

2. Circuit selon la revendication 1, caractérisé en ce que les variables d'entrée (A, B, C, D1 à D4) sont des signaux d'adressage (A, B, C) et/ou des signaux de données (D1 à D4) et leurs signaux complémentaires.

3. Circuit selon la revendication 1 ou 2, caractérisé en ce qu'une partie des variables d'entrée (D1 à D4) attaquent l'étage de niveau de tension supérieur (VB1).

4. Circuit selon une des revendications 1 à 3, caractérisé en ce que des variables d'entrée (A, B, C) attaquent des circuits de commande d'étages à couplage combinatoire sériel à travers des émetteurs-suiveurs (TA, TB, TC).

5. Circuit selon une des revendications 1 à 4, caractérisé en ce qu'un étage à couplage combinatoire sériel contient au moins deux interrupteurs de courant ECL (DA, DB; ED1 à ED4) commandés chacun par une variable d'entrée (A, B, C, D1 à D4).

6. Circuit selon une des revendications 1 à 5, caractérisé en ce qu'au moins un circuit de commande (ED1 à ED4, TP1, TP'1, TP2, TP'2) d'interrupteurs de courant ECL contient un transistor (ED1 à ED4) et/ou les deux amplificateurs différentiels (TP1, TP'1, TP2, TP'2).

7. Circuit selon une des revendications 1 à 6, caractérisé en ce qu'au moins un circuit de commande et/ou un circuit de référence (TE1 à TE2) d'au moins deux interrupteurs de courant ECL d'un étage à couplage combinatoire sériel, contient au moins un transistor à plusieurs émetteurs.

8. Circuit selon une des revendications 1 à 7, caractérisé en ce que les résistances (R, R') réalisent une conjonction logique entre des signaux d'adressage (A, B, C) et/ou des signaux de données (D1 à D4) et/ou des signaux dépendant de ceux-ci et/ou des signaux de sortie d'un étage de niveau de tension (VB2, VB3).

9. Circuit selon une des revendications 1 à 8, caractérisé en ce que les signaux d'entrée des deux amplificateurs différentiels (TP1, TP'1, TP2, TP'2) sont des signaux de sortie complémentaires d'un étage à couplage combinatoire sériel.

10. Circuit selon une des revendications 1 à 8, caractérisé en ce que les signaux d'entrée des deux amplificateurs différentiels (TP1, TP'1, TP2, TP'2) sont formés à partir de la conjonction logique de signaux de sortie complémentaires d'un étage à couplage combinatoire sériel et d'un signal dépendant d'une variable d'entrée (C), par addition de tensions sur les résistances (R, R').

11. Circuit selon une des revendications 1 à 10, caractérisé en ce que les résistances (R, R') servent à l'adaptation interne au circuit du niveau de tension.

EP 0 176 908 B1

# FIG 1

# FIG 2